# DEMANDE DE BREVET EUROPEEN

(11) **EP 4 521 866 A1**
(43) Date de publication de la demande: **12.03.2025**
(21) Numéro de dépôt: 24198305.5
(22) Date de dépôt: 03.09.2024
(51) Int. Cl.: H05K 7/14, H02M 3/00, H02M 3/156

(54) **CONVERTISSEUR ÉLECTRIQUE CONTINU-CONTINU ET ENGIN DE MOBILITÉ COMPORTANT UN TEL CONVERTISSEUR**

(30) Priorité: 04.09.2023 FR 2309269
(71) Demandeur: Valeo eAutomotive Germany GmbH, 91056 Erlangen (DE)
(72) Inventeur: GILET, Olivier, 95892 CERGY PONTOISE (FR); CRAVO, David, 95892 CERGY PONTOISE (FR)
(74) Mandataire: Valeo Powertrain Systems

(57) **Abrégé**

Le convertisseur comporte : - un circuit électrique de conversion conçu pour convertir une tension d'entrée continue en une tension de sortie continue ; - un connecteur d'entrée ou bien de sortie, comportant : deux broches (B+, B-), l'une (B+) positive et l'autre (B-) négative, conçues pour recevoir la tension d'entrée (VIN) ou bien pour fournir la tension de sortie, et deux barres omnibus auxiliaires plates (BA+, BA-), l'une (BA+) positive et l'autre (BA-) négative, chaque barre omnibus auxiliaire plate (BA+, BA-) comportant une première portion plane (BA1+, BA1-) plaquée et fixée contre la broche positive (B+), respectivement négative (B-), et une deuxième portion plane (BA2+, BA2-), ces deuxièmes portions planes (BA2+, BA2-) étant sensiblement parallèles l'une à l'autre, par exemple coplanaires, la première portion plane (BA1+) de la barre omnibus auxiliaire plate positive (BA+) étant plaquée et fixée contre une portion de fixation plane (B1+) de la broche positive (B+), et la première portion plane (BA1-) de la barre omnibus auxiliaire plate négative (BA-) étant plaquée et fixée contre une portion de fixation plane (B1-) de la broche négative (B-) et ; et - deux barres omnibus principales positive (BP+) et négative (BP-) connectées au circuit électrique de conversion (218) et comportant respectivement des portions planes (BP2+, BP2-) plaquées et fixées respectivement contre les deuxièmes portions (BA2+, BA2-) des barres omnibus auxiliaire (BA+, BA-).

## Description

### Domaine technique de l'invention

La présente invention concerne un convertisseur électrique continu-continu et un engin de mobilité comportant un tel convertisseur.

Un engin de mobilité est par exemple un véhicule terrestre à moteur, un train, un aéronef ou bien un drone. Un véhicule terrestre à moteur est par exemple un véhicule automobile, une moto, un vélo motorisé ou bien un fauteuil roulant motorisé.

### Arrière-plan technologique

On connait de l'état de la technique un convertisseur électrique continu-continu comportant :
- un circuit électrique de conversion conçu pour convertir une tension d'entrée continue en une tension de sortie continue ;
- un connecteur d'entrée ou bien de sortie, comportant deux broches plates, l'une positive et l'autre négative, conçues pour recevoir la tension d'entrée ou bien pour fournir la tension de sortie ;
- deux barres omnibus principales positive et négative connectées au circuit électrique de conversion.

Généralement, afin de connecter le connecteur au circuit électrique, les broches du connecteur sont plaquées et fixées contre les barres omnibus principales. En fonction des contraintes d'implémentation du convertisseur électrique continu-continu dans son environnement, le connecteur doit présenter une orientation adaptée à cet environnement. Ainsi, à chaque conception d'un nouveau produit avec un convertisseur électrique continu-continu, il est nécessaire de modifier les broches du connecteur et/ou les barres omnibus principales pour tenir compte de cette orientation. Cela entraîne donc des coûts de conception et de production non négligeables.

Il peut ainsi être souhaité de prévoir un convertisseur électrique continu-continu qui permette de s'affranchir d'au moins une partie des problèmes et contraintes précités.

### Résumé de l'invention

Il est donc proposé un convertisseur électrique continu-continu comportant :
- un circuit électrique de conversion conçu pour convertir une tension d'entrée continue en une tension de sortie continue ;
- un connecteur d'entrée ou bien de sortie, dit premier connecteur, comportant :
   - deux broches, l'une positive et l'autre négative, conçues pour recevoir la tension d'entrée ou bien pour fournir la tension de sortie, et
   - deux barres omnibus auxiliaires plates, l'une positive et l'autre négative, chaque barre omnibus auxiliaire plate comportant une première portion plane plaquée et fixée contre la broche positive, respectivement négative, et une deuxième portion plane, ces deuxièmes portions planes étant sensiblement parallèles l'une à l'autre, par exemple coplanaires, la première portion plane de la barre omnibus auxiliaire plate positive étant plaquée et fixée contre une portion de fixation plane de la broche positive, et la première portion plane de la barre omnibus auxiliaire plate négative étant plaquée et fixée contre une portion de fixation plane de la broche négative, et comportant une portion de liaison directement adjacente à la première portion et à la deuxième portion ; et
- deux barres omnibus principales positive et négative connectées au circuit électrique de conversion et comportant respectivement des portions planes plaquées et fixées respectivement contre les deuxièmes portions des barres omnibus auxiliaire.

Ainsi, grâce à l'invention, à chaque conception d'un nouveau produit, seule les barres omnibus auxiliaires ont besoin d'être adaptées à l'orientation souhaitée du connecteur. Les broches de ce dernier, ainsi que les barres omnibus principales, peuvent être laissées inchangées.

L'invention peut en outre comporter l'une ou plusieurs des caractéristiques optionnelles suivantes, selon toute combinaison techniquement possible.

De façon optionnelle, la portion de liaison de chaque barre omnibus auxiliaire comprend une pliure de sorte que la première portion et la deuxième portion de chaque barre omnibus auxiliaire fassent entre elles un angle non plat.

Ainsi, il est possible d'adapter facilement les barres omnibus auxiliaires à l'orientation souhaitée grâce à la pliure.

De façon optionnelle également, la portion de liaison des barres omnibus auxiliaires comprend une unique pliure reliant la première portion et la deuxième portion.

Il s'agit d'un mode de réalisation où les barres omnibus auxiliaires sont gardées aussi simples que possibles pour faciliter leur adaptation.

De façon optionnelle également, la portion de liaison de chaque barre omnibus auxiliaire est dans un sens de circulation du courant au sein de la barre omnibus auxiliaire plus courte que la première portion et plus courte que la deuxième portion.

Par sens de circulation en entend la direction du courant traversant la barre omnibus auxiliaire.

Il s'agit d'un mode de réalisation avantageux de par le fait qu'il réduit l'encombrement du convertisseur.

De façon optionnelle également, les deuxièmes portions des barres omnibus auxiliaires sont fixées aux barres omnibus principales par vissage selon une direction de vissage sensiblement perpendiculaire aux deuxièmes portions des barres omnibus auxiliaire.

De façon optionnelle également, les premières portions des barres omnibus auxiliaires sont fixées aux portions de fixation planes des broches par soudage.

De façon optionnelle également, le convertisseur électrique continu-continu comporte un boîtier muni d'un fond avec au moins une partie plane, et les deuxièmes portions des barres omnibus auxiliaires sont sensiblement parallèles à la partie plane du fond.

De façon optionnelle également, les portions de fixation planes des broches s'étendent sensiblement parallèlement l'une en face de l'autre et présentent des faces en vis-à-vis et des faces externes, de l'autre côté des faces en vis-à-vis, sur lesquelles les premières portions des barres omnibus auxiliaires sont plaquées et fixées.

De façon optionnelle également, chaque broche comporte une portion d'extrémité plane, ces portions d'extrémité planes s'étendant sensiblement parallèlement l'une en face de l'autre, à une distance plus grande que les portions de fixation, et le connecteur comporte en outre un tore magnétique entourant les portions de fixation des broches.

De façon optionnelle également, le connecteur comporte en outre :
- une première capacité connectée entre la broche positive et une masse électrique, cette première capacité étant connectée à la broche positive entre le tore magnétique et sa portion d'extrémité ; et/ou
- une deuxième capacité connectée entre la broche négative et la masse électrique, cette deuxième capacité étant connectée à la broche négative entre le tore magnétique et sa portion d'extrémité.

De façon optionnelle également, le convertisseur électrique continu-continu comporte un autre connecteur d'entrée ou bien de sortie, similaire au premier connecteur. « Similaire » signifie comportant :
- deux broches, l'une positive et l'autre négative, conçues pour recevoir la tension d'entrée ou bien pour fournir la tension de sortie, et
- deux barres omnibus auxiliaires plates, l'une positive et l'autre négative, chaque barre omnibus auxiliaire plate comportant une première portion plane plaquée et fixée contre la broche positive, respectivement négative, et une deuxième portion plane, ces deuxièmes portions planes étant sensiblement parallèles l'une à l'autre, par exemple coplanaires, la première portion plane de la barre omnibus auxiliaire plate positive étant plaquée et fixée contre une portion de fixation plane de la broche positive, et la première portion plane de la barre omnibus auxiliaire plate négative étant plaquée et fixée contre une portion de fixation plane de la broche négative.

Les première et deuxième portions planes des barres omnibus auxiliaire de cet autre connecteur font alors entre elles un angle différent de l'angle entre les première et deuxième portions planes du premier connecteur, de sorte que les deuxièmes portions planes de cet autre connecteur soient parallèles à celles du premier connecteur.

De façon optionnelle également, l'autre connecteur est un connecteur d'entrée et le premier connecteur est un connecteur de sortie.

De façon optionnelle également, l'autre connecteur est un connecteur de sortie et le premier connecteur est un connecteur d'entrée.

De façon optionnelle également, les broches positives et les broches négatives des deux connecteurs sont identiques, en particulier de même forme.

Il est également proposé un engin de mobilité comportant un convertisseur électrique continu-continu selon l'invention.

### Brève description des figures

L'invention sera mieux comprise à l'aide de la description qui va suivre, donnée uniquement à titre d'exemple et faite en se référant aux dessins annexés dans lesquels :
- la figure 1 est une vue simplifiée d'un engin de mobilité dans lequel l'invention peut être mise en oeuvre,
- la figure 2 est une vue simplifiée en trois dimensions d'un convertisseur électrique continu-continu de l'engin de mobilité de la figure 1,
- la figure 3 est une vue en trois dimensions d'un connecteur du convertisseur de la figure 2,
- la figure 4 est une vue en trois dimensions du connecteur de la figure 3, selon un angle de vue différent et en l'absence d'un tore magnétique,
- la figure 5 est une vue en trois dimensions d'un filtre de compatibilité électromagnétique associé au connecteur des figures 3 et 4,
- la figure 6 est une vue en trois dimensions du filtre de compatibilité électromagnétique, isolé du connecteur,
- la figure 7 est une vue du compatibilité électromagnétique où sont représentés les emplacements d'éléments d'un outil de fixation de pinces,
- la figure 8 est une vue similaire à celle de la figure 7 sans décalage vertical de deux capacités,
- la figure 9 est une vue en trois dimensions du connecteur des figures 3 et 4 et d'un autre connecteur du convertisseur électrique continu-continu,
- la figure 10 est une vue en trois dimension de l'autre connecteur et d'un filtre de compatibilité électromagnétique associé.
- la figure 11 est une série de vues en trois dimensions illustrant les étapes successives d'un procédé de fabrication de l'autre connecteur représenté sur les figure 9 et 10,

### Description détaillée de l'invention

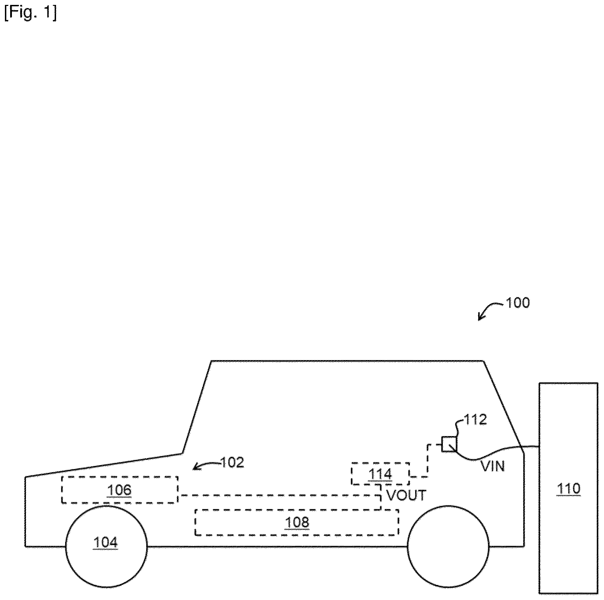

En référence à la figure 1, un engin de mobilité 100 dans lequel l'invention peut être utilisée, va à présent être décrit.

L'engin de mobilité 100 comporte un système de propulsion 102, par exemple des roues motrices 104 et un moteur électrique 106 conçu pour entraîner les roues motrices 104. L'engin de mobilité 100 comporte en outre une batterie 108 conçue pour alimenter électriquement le moteur électrique 106.

Pour recharger la batterie 108 à une station de recharge 110 connectée à un réseau de distribution électrique (non représenté), l'engin de mobilité 100 comporte en outre une prise électrique 112 conçue pour être connectée à la station de recharge 110, ainsi qu'un convertisseur électrique continu-continu 114 connecté entre la prise électrique 112 et la batterie 108, afin de convertir une tension d'entrée VIN reçue de la station de recharge 110 au travers de la prise électrique 112 en une tension de sortie VOUT fournie à la batterie 108.

Dans la suite de la description, la disposition des différents éléments du convertisseur 114 fera référence à un repère arbitraire comportant un axe gauche-droite X, un axe bas-haut Y et un axe avant-arrière Z.

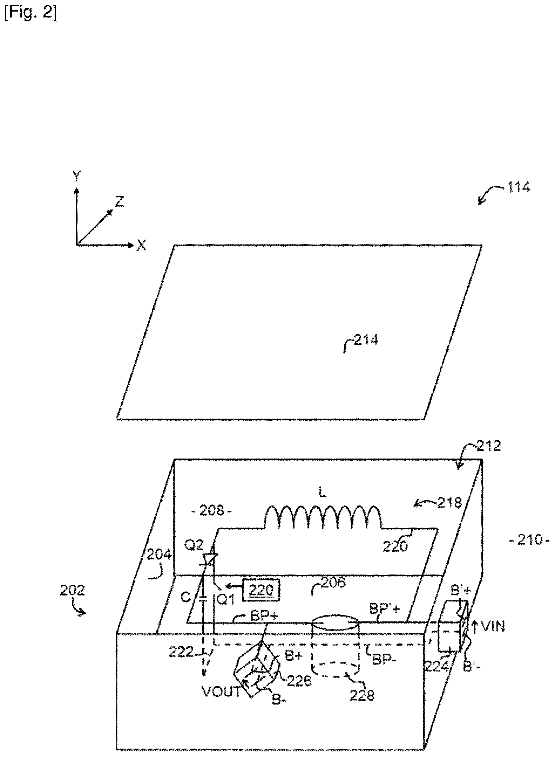

En référence à la figure 2, le convertisseur 114 va à présent être décrit plus en détail.

Le convertisseur 114 comporte tout d'abord un boîtier 202 comportant des parois latérales 204 et un fond 206 définissant ensemble un espace intérieur 208 du boîtier 202 et un espace extérieur 210 au boîtier 202. Les parois latérales 204 peuvent en outre définir, à l'opposé du fond 206, une ouverture supérieure 212. Dans ce cas, le boîtier 202 peut en outre comporter un couvercle 214 conçu pour fermer l'ouverture supérieure 212.

Le convertisseur 114 comporte en outre un circuit électrique de conversion 218 s'étendant dans l'espace intérieur 208 du boîtier 202. Le circuit électrique de conversion 218 est conçu pour convertir la tension d'entrée VIN en la tension de sortie VOUT. Par exemple, le convertisseur 114 peut être un hacheur parallèle (« boost converter » ou bien « step-up converter » en anglais), auquel cas le circuit de conversion 218 comporte par exemple une branche positive 220 et une branche négative 222, présentant un côté d'entrée et un côté de sortie. Le circuit de conversion 218 comporte une inductance L sur la branche positive, ainsi qu'un interrupteur Q1 et une capacité C, en parallèle l'un de l'autre entre la branche positive 220 et la branche négative 222, du côté de sortie par rapport à l'inductance L, et un autre interrupteur Q2 sur la branche positive, entre l'interrupteur Q1 et la capacité C, par exemple une diode passante vers la capacité C (sa cathode du côté de la capacité C). Le convertisseur 114 comporte alors en outre un circuit de commande 220 conçu pour commander l'interrupteur Q pour réaliser la conversion.

Pour recevoir la tension d'entrée VIN, le convertisseur 114 comporte en outre un connecteur d'entrée 224 accessible depuis l'espace extérieur 210 afin d'être connecté à la prise externe 112 par une connexion électrique (non représentée) présentant, à l'une de ses extrémités, un connecteur complémentaire du connecteur d'entrée 224. Le connecteur d'entrée 224 comporte ainsi deux broches d'entrée B'+, B'- : la première broche B'+ est dite positive pour recevoir le potentiel positif de la tension d'entrée VIN et la deuxième broche B'- est dite négative pour recevoir le potentiel négatif de la tension d'entrée VIN.

Pour fournir la tension de sortie VOUT, le convertisseur 114 comporte en outre un connecteur de sortie 226 accessible depuis l'espace extérieur 210 afin d'être connecté à la batterie 108 par une connexion électrique (non représentée) présentant, à l'une de ses extrémités, un connecteur complémentaire du connecteur de sortie 226. Le connecteur de sortie 226 comporte ainsi deux broches de sortie B+, B- : la première broche B+ est dite positive pour fournir le potentiel positif de la tension de sortie VOUT et la deuxième broche B- est dite négative pour fournir le potentiel négatif de la tension de sortie VOUT.

Pour connecter les potentiels négatifs entre eux, le convertisseur 114 comporte une deuxième barre omnibus principale, dite négative, BP- connectant la broche d'entrée négative B'- et la broche de sortie négative B- entre elles, ainsi qu'à la ligne négative 222 du circuit de conversion 218.

Le convertisseur 114 comporte en outre une barre omnibus principale d'entrée positive BP'+ connectant la broche d'entrée positive B'+ au côté d'entrée de la branche positive 220 du circuit de conversion 218, et une première barre omnibus principale, dite de sortie positive, BP+ connectant la broche de sortie positive B+ au côté de sortie de la branche positive 220 du circuit de conversion 218.

Le convertisseur 114 peut en outre comporter un commutateur 228 pour sélectivement connecter et déconnecter les barres omnibus principales positives BP+, BP'+. Cela permet de court-circuiter le circuit de conversion 218 pour que la tension de sortie VOUT soit égale à la tension d'entrée VIN. Cette fonction est utile par exemple lorsque la station de recharge 110 fournit une tension d'entrée VIN qui est déjà à la tension nécessaire pour la recharge de la batterie 108.

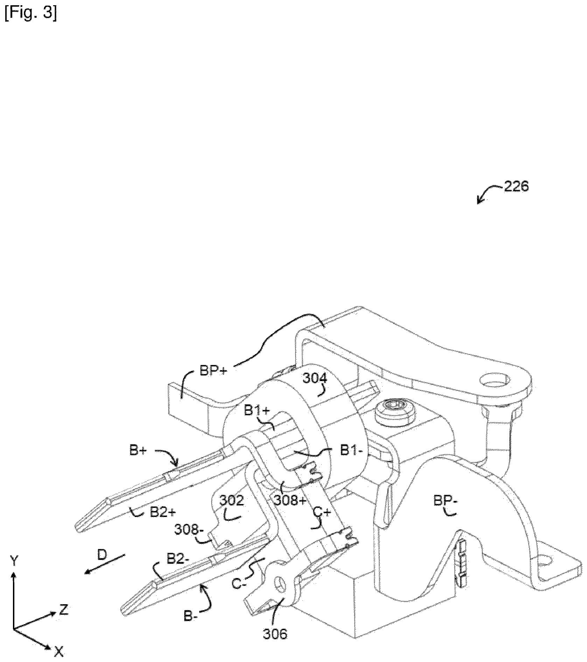

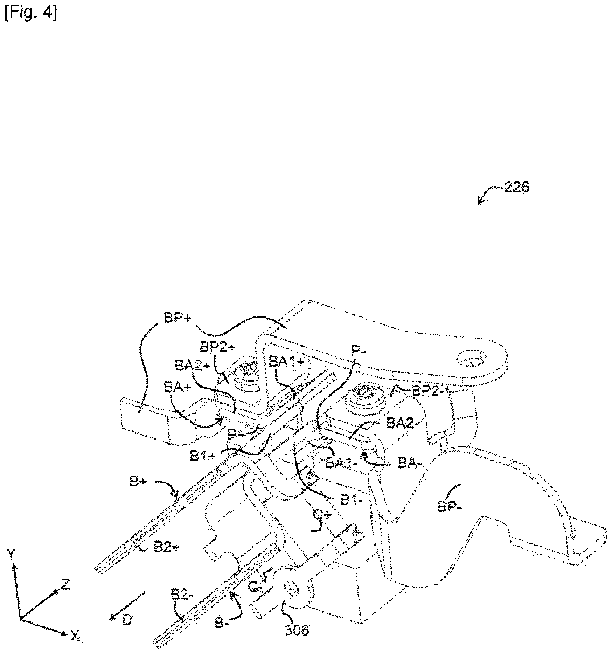

En référence aux figures 3 et 4, le connecteur de sortie 226 va à présent être décrit plus en détail.

En référence à la figure 3, les broches de sortie B+, B- comportent par exemple respectivement deux barres omnibus plates, par exemple avec une épaisseur comprise entre 1 mm et 5 mm, par exemple 4 mm, présentant chacune une portion de fixation plane B1+, B1- et une portion d'extrémité plane B2+, B2-. Les portions d'extrémité B2+, B2- se projettent par exemple vers l'espace extérieur 210 selon un axe D (dans le sens avant dans l'exemple illustré) et sont conçues pour être connectées au connecteur complémentaire du connecteur de sortie 226 selon cet axe D. Dans d'autres modes de réalisation, le portions d'extrémité B2+, B2- pourrait avoir une géométrie autre que plane, par exemple une géométrie de tige à section circulaire se projetant selon l'axe D.

Les portions de fixation planes B1+, B1- s'étendent sensiblement parallèlement, par exemple à 1° près, l'une en face de l'autre, par exemple à moins de 10 mm l'une de l'autre, par exemple à 4 mm l'une de l'autre. De même, les portions d'extrémité planes B2+, B2- s'étendent sensiblement parallèlement, par exemple à 1° près, l'une en face de l'autre, mais à une distance plus grande que les portions de fixation planes B1+, B1-, par exemple au moins deux fois plus grande, par exemple entre 20 mm et 30 mm l'une de l'autre, par exemple à 25,7 mm l'une de l'autre. Par exemple, l'une des broches de sortie B+, B- (par exemple la broche de sortie positive B+, comme dans l'exemple illustré) est plane, tandis que l'autre des broches de sortie B+, B- (par exemple la broche de connexion négative B-, comme dans l'exemple illustré) présente une jonction 302 entre la portion d'extrémité B2- et la portion de fixation B1-, cette jonction 302 présentant deux coudes par exemple réalisés en pliant la broche de connexion B- dans sa largeur.

Le connecteur de sortie 226 comporte en outre un premier filtre de compatibilité électromagnétique. Ce premier filtre comporte par exemple tout d'abord un tore magnétique 304 entourant les broches de sortie B+, B-, et plus précisément les portions de fixation B1+, B1- du fait de leur écartement faible. Le premier filtre comporte en outre par exemple deux capacités C+, C- connectées entre une barre omnibus 306 connectée à une masse électrique (par exemple, le boîtier 202) et respectivement la broche de sortie positive B+ et la broche de sortie négative B-. Par exemple, la broche de sortie positive B+ comporte une patte 308+ s'étendant depuis la barre omnibus plate jusqu'à la capacité C+. De même, la broche de sortie négative B- peut comporter une patte 308- s'étendant depuis la barre omnibus plate jusqu'à la capacité C-. Ces pattes 308+, 308- sont situées entre le tore magnétique 304 et les portions extrémités B2+, B2- des broches de sortie B+, B-.

En référence à la figure 4, le connecteur de sortie 226 comporte en outre deux barres omnibus auxiliaires BA+, BA-. La première BA+ est dite positive et intercalée entre la broche positive B+ et la barre omnibus principale positive BP+. La deuxième BA- est dite négative et intercalée entre la broche négative B- et la barre omnibus négative BP-.

Ainsi, chaque barre omnibus auxiliaire BA+, BA- comporte une première portion plane BA1+, BA1- fixée sur la broche positive B+, respectivement négative B-, et plus précisément sur sa portion de fixation B1+, respectivement B1-. Les portions planes BA1+, BA1- des barres omnibus auxiliaires BA+, BA- sont par exemple plaquées et fixées contre des faces des portions de fixation B1+, B1-. Par exemple, les portions de fixation B1+, B1- présentent des faces en vis-à-vis (se faisant face) et des faces externes, de l'autre côté des faces en vis-à-vis. Ainsi, les portions planes BA1+, BA1- des barres omnibus auxiliaires BA+, BA- sont par exemple plaquées et fixées contre ces faces externes (comme dans l'exemple illustré).

Chaque barre omnibus auxiliaire BA+, BA- comporte en outre une deuxième portion plane BA2+, BA2-. Ces deuxièmes portions planes BA2+, BA2- sont sensiblement parallèles, par exemple à 1° près, l'une à l'autre, par exemple coplanaires. Suivant l'orientation des broches de sortie B+, B- autour de leur axe D, chaque portion BA2+, BA2- peut s'étendre dans la continuité de la première portion plane BA1+, BA1- (auquel cas les barres omnibus auxiliaires BA+, BA- sont planes) ou bien avec un angle non plat (comme dans l'exemple illustré). Dans ce dernier cas, chaque barre omnibus auxiliaire BA+, BA- présente par exemple une pliure P+, P-entre les portions BA1+, BA2+ et BA1-, BA2-, sensiblement parallèle à l'axe D, par exemple à 1° près.

Des portions planes BP2+, BP2- de respectivement les barres omnibus principales BP+, BP- sont plaquées et fixées respectivement contre les deuxièmes portions BA2+, BA2- des barres omnibus auxiliaire BA+, BA-. Du fait que les deuxièmes portions BA2+, BA2- s'étendent parallèlement, leur fixation peut être réalisée de manière similaire, en particulier selon un même axe de fixation, quelle que soit l'orientation des broches de sortie B+, B- autour de l'axe D. En particulier, lorsque cette fixation est faite par vissage (comme dans l'exemple illustré), le vissage peut être réalisé selon l'axe perpendiculaire aux deuxièmes portions BA2+, BA2-, verticalement dans l'exemple illustré. Cet axe de vissage peut également être utilisé pour d'autre vis du convertisseur 114. Ainsi, un même outil peut être utilisé pour réaliser tous ces vissages, quelle que soit l'orientation des broches B+, B- autour de leur axe D.

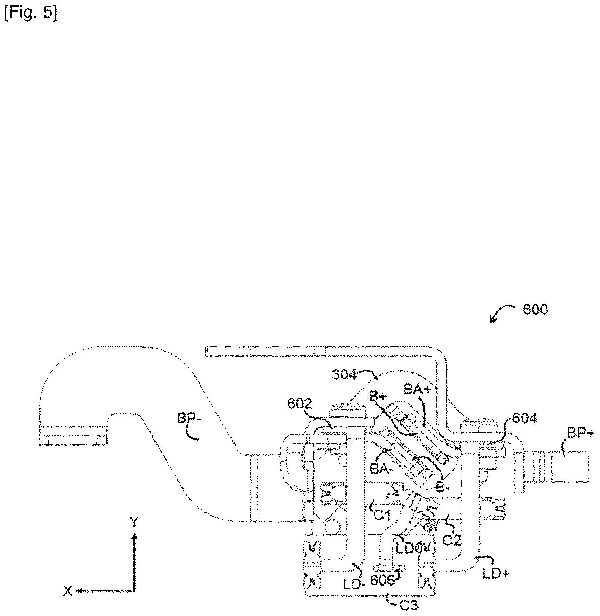

En référence à la figure 5, le convertisseur 114 comporte en outre un deuxième filtre de compatibilité électromagnétique 600 pour le connecteur de sortie 226.

Ce filtre de compatibilité électromagnétique 600 comporte tout d'abord une barre omnibus négative LD- connectée à la barre omnibus principale négative BP-. Pour cela, la barre omnibus négative LD- comporte par exemple une borne de fixation 602 fixée à la barre omnibus principale négative BP-, par exemple par la même vis que la barre omnibus auxiliaire négative BA-. Le filtre de compatibilité électromagnétique 600 comporte en outre une barre omnibus positive LD+ connectée à la barre omnibus de sortie principale positive BP+. Pour cela, la barre omnibus LD+ comporte par exemple une borne de fixation 604 fixée à la barre omnibus de sortie principale positive BP+, par exemple par la même vis que la barre omnibus auxiliaire positive BA+. Le filtre de compatibilité électromagnétique 600 comporte en outre une barre omnibus de masse LD0 connectée à la masse électrique, par exemple au boîtier 202. Pour cela, la barre omnibus de masse LD0 comporte une borne de fixation 606 fixée à la masse électrique.

Le filtre de compatibilité électromagnétique 600 comporte en outre une capacité C1 connectée entre la barre omnibus négative LD- et la barre omnibus de masse LD0, une capacité C2 connectée entre la barre omnibus positive LD+ et la barre omnibus de masse LD0, et une capacité C3 connectée entre la barre omnibus positive LD+ et la barre omnibus négative LD-. Toutes les capacités C1, C2, C3 présentent par exemple des boîtiers respectifs de forme générale parallélépipédique avec des faces supérieures horizontales, parallèles entre elles, perpendiculaires à l'axe Y.

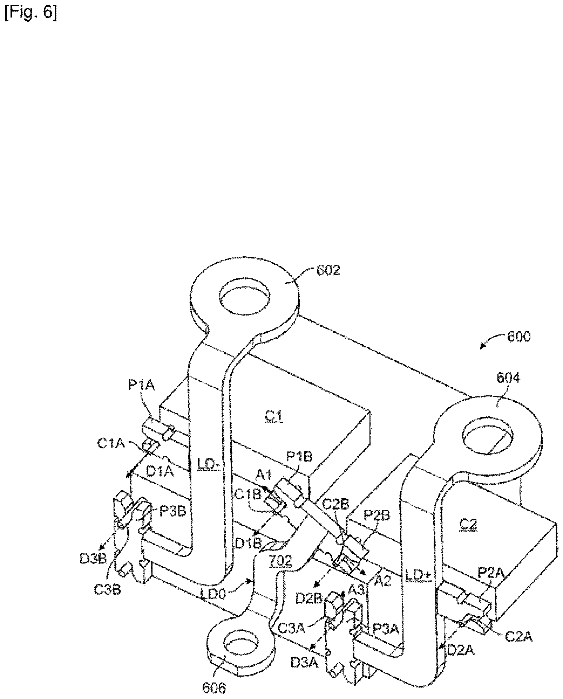

En référence à la figure 6, pour être connectée, la capacité C1 comporte deux broches C1A, C1B se projetant selon des axes D1A, D1B, parallèles à l'axe Z dans l'exemple illustré. Ainsi, la barre omnibus négative LD- comporte une pince P1A enserrant la broche C1A et la barre omnibus de masse LD0 présente une pince P1B enserrant la broche C1B. La pince P1B se projette, c'est-à-dire s'ouvre, selon un axe dit oblique et un sens A1 sur cet axe.

De même, pour être connectée, la capacité C2 comporte deux broches C2A, C2B se projetant selon des axes D2A, D2B. Ainsi, la barre omnibus positive LD+ comporte une pince P2A enserrant la broche C2A et la barre omnibus de masse LD0 présente une pince P2B enserrant la broche C2B. La pince P2B se projette, c'est-à-dire s'ouvre, selon le même axe, par exemple à 1° près, que l'axe de la pince P1B, et dans un sens A2. Les pinces P1B et P2B sont positionnées tête-bêche, c'est-à-dire que les sens A1, A2 sont opposées.

De même, pour être connectée, la capacité C3 comporte deux broches C3A, C3B (pouvant être chacune dédoublée comme dans l'exemple illustré) se projetant selon des sens avant D3A, D3B. Ainsi, la barre omnibus positive LD+ présente une pince P3A enserrant la broche C3A. Cette pince P3A se projette, c'est-à-dire s'ouvre, dans l'axe vertical Y dans le sens A3 vers le haut. La barre omnibus négative LD-présente elle-aussi une pince P3B qui se projette, c'est-à-dire s'ouvre, dans l'axe vertical Y dans le sens A3 vers le haut et enserrant la broche C3B.

Le conducteur de masse LD0 comporte un corps allongé 702 s'étendant depuis les pinces P1B, P2B vers le bas, au moins jusqu'au niveau de la broche C3A. Par exemple, la borne 606 du conducteur de masse LD0 est située plus bas que cette broche C3A, de sorte que le corps allongé 702 passe sur le côté de la broche C3A et entre les broches C3A et C3B.

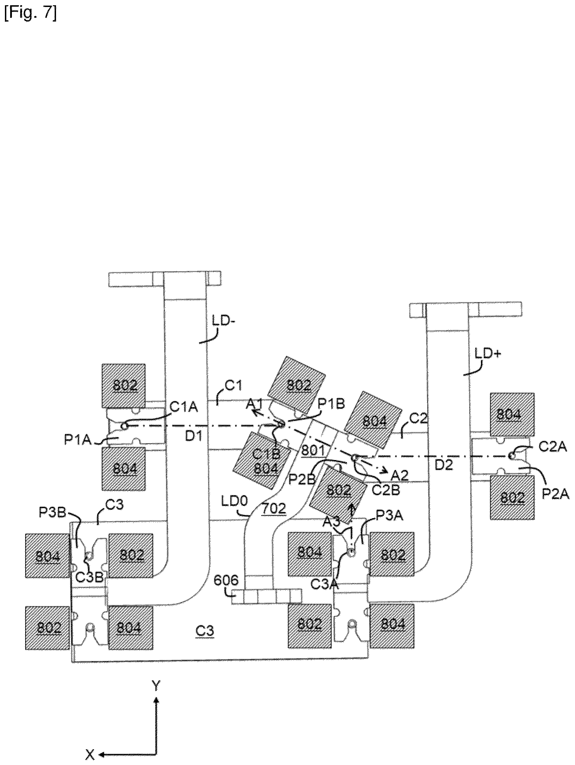

Or, en référence à la figure 7, lors de la fabrication du filtre de compatibilité électromagnétique 600, chaque pince P1A, P1B, P2A, P2B, P3A, P3B est refermée sur sa broche C1A, C1B, C2A, C2B, C3A, C3B associée par un outil, en particulier une pince de fixation présentant deux éléments 802, 804 conçus pour être placés respectivement de chaque côté de la pince P1A, P1B, P2A, P2B, P3A, P3B. La pince de fixation peut être une pince d'enserrage, auquel cas les éléments sont conçus pour se rapprocher l'un de l'autre pour pousser mécaniquement respectivement les deux branches de la pince P1A, P1B, P2A, P2B, P3A, P3B pour qu'elles enserrent la broche associée C1A, C1B, C2A, C2B, C3A, C3B. La pince de fixation peut également être une pince à soudure électrique, auquel cas les éléments 802, 804 forment en outre ou alternativement des électrodes pour faire passer un courant au travers de la pince P1A, P1B, P2A, P2B, P3A, P3B et de la broche C1A, C1B, C2A, C2B, C3A, C3B associée pour les souder l'une à l'autre.

Ainsi, pour laisser suffisamment de place à ces éléments 802, 804, le corps allongé de la barre omnibus de masse LD0 doit passer à distance de la pince P3A.

En outre, afin que le filtre de compatibilité électromagnétique 600 soit le plus compact possible, il est souhaitable que les capacités C1 et C2, qui s'étendent au-dessus de la capacité C3, soient les plus proches possible de cette dernière.

Pour satisfaire ces deux contraintes, la capacité C1 est placée de sorte que sa broche C1B soit située plus haut que la broche C2B de la deuxième capacité C2. Ainsi, les sens opposés A1, A2 et le sens A3 font entre eux un angle inférieur à 80°, de préférence inférieur à 70°, par exemple 65°, ce qui permet au corps allongé 702 de présenter une portion d'extrémité droite 801, de laquelle les pinces P1B, P2B se projettent sensiblement perpendiculairement, par exemple à 1° près, qui est verticalement en biais pour s'éloigner de la pince P3A. Ainsi, il est possible de garder une distance suffisante entre la pince P3A et le corps allongé 702 pour le passage des éléments 802, 804 (en particulier de l'élément 804) de l'outil, tout en gardant la capacité C2 basse, proche de la capacité C3.

Par exemple, la capacité C1 est placée de sorte que sa face supérieure s'étende plus haut que la face supérieure de la capacité C2, c'est-à-dire à une hauteur plus élevée. Par exemple, la hauteur de la face supérieure de la capacité C1 est au moins 5 mm, de préférence au moins 10 mm, plus élevée que la hauteur de de la face supérieure de la capacité C2.

Toujours par exemple, les broches de chaque capacité C1, C2 définissent une ligne droite D1, D2. Ces deux lignes droites D1, D2 sont sensiblement parallèles, par exemple à 1° près, avec la ligne D1 au-dessus de la ligne D2, par exemple au moins 5 mm au-dessus, par exemple entre 5 mm et 10 mm au-dessus.

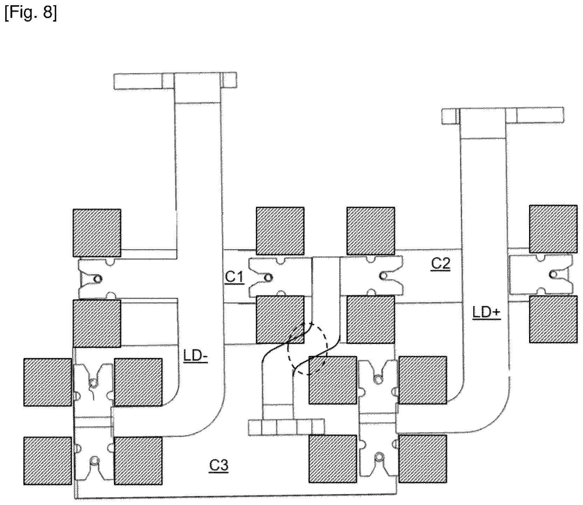

En référence à la figure 8, si la capacité C1 était placée au même niveau que la capacité C2, le corps allongé 702 s'étendrait trop proche de la pince P1B et/ou de la pince P3A pour permettre le passage des éléments 802, 804 de l'outil (voir la zone entourée en pointillés).

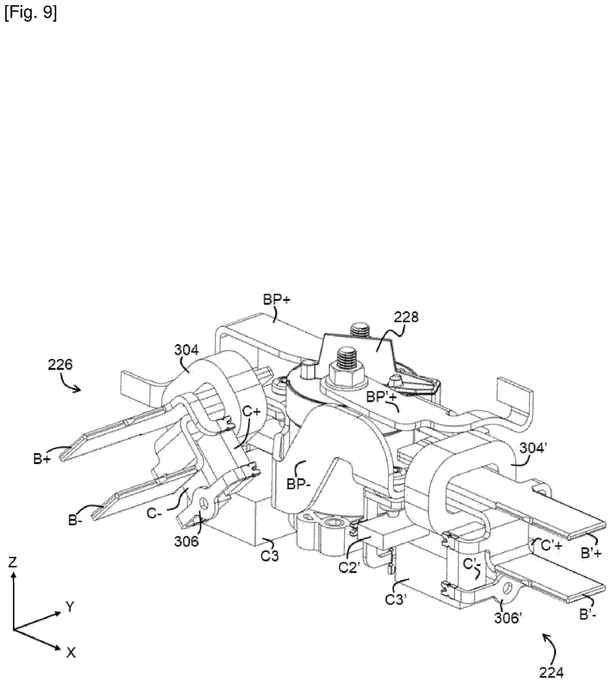

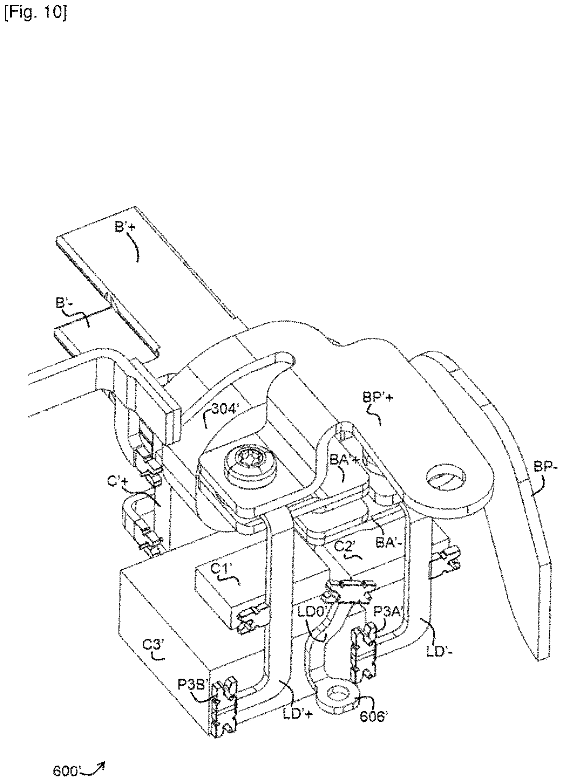

En référence à la figure 9 et 10, le connecteur d'entrée 224 présente des éléments similaires à ceux du connecteur de sortie 226, pour lesquels les références des figures précédentes sont reprises, avec « ' » pour les distinguer. Les broches d'entrée B'+, B'- sont identiques aux broches de sortie B+, B', en particulier de même forme. Les broches d'entrée B'+, B'- s'étendent horizontalement, c'est-à-dire perpendiculairement à la direction de fixation (par exemple de vissage). Ainsi, il n'y a pas d'angle à compenser, de sorte que les barres omnibus auxiliaires BA'+, BA'- sont plates.

En outre, un filtre de compatibilité électromagnétique 600' est également prévu derrière le connecteur d'entrée 224 et présente des éléments similaires à ceux du filtre de compatibilité électromagnétique 600, pour lesquels les références des figures précédentes sont reprises, avec « ' » pour les distinguer. En particulier, comme précédemment, les capacités C1', C2' sont décalées verticalement afin de faciliter le passage de la barre omnibus LD0' à distance de la pince

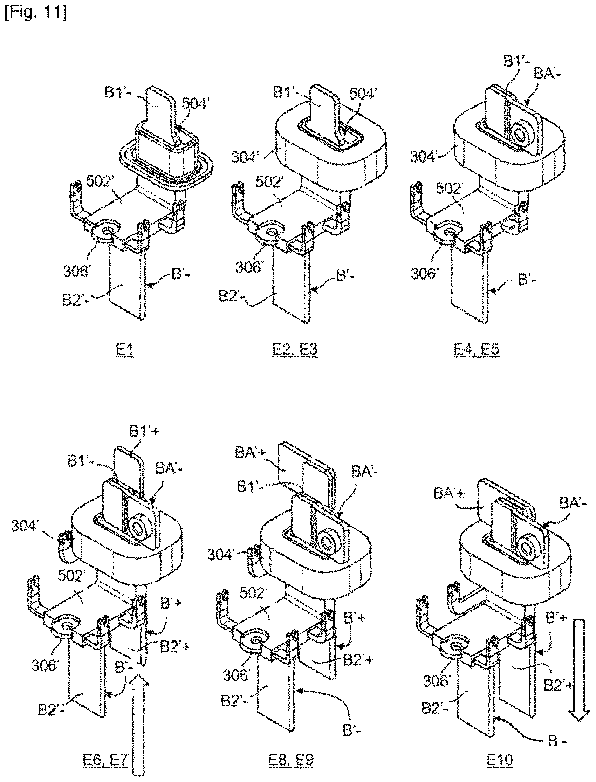

En référence à la figure 11, un exemple de procédé de fabrication du connecteur d'entrée 224 est décrit.

Le connecteur de sortie 226 est obtenu par un procédé identique.

Au cours d'une étape E1, on obtient la broche négative B'- et, par exemple, la barre omnibus 306'. Les deux sont par exemple obtenues surmoulées par un surmoulage 502', laissant apparent les portions B1 '-, B2'- de la broche négative B'-. Le surmoulage 502' présente en outre une ouverture traversante 504' dans une partie du surmoulage 502' surmoulant la portion B1 '- de la broche négative B'-. Dans d'autres exemples de réalisation, le surmoulage 502' pourrait être dépourvu d'ouverture traversante 504'.

Au cours d'une étape E2, on obtient le tore magnétique 304'.

Au cours d'une étape E3, la broche négative B'- est insérée, par sa portion de fixation B1'-, dans le tore magnétique 304', par exemple jusqu'à ce que le tore 304' s'étende autour du surmoulage 502', par exemple autour de la partie du surmoulage 302' présentant l'ouverture traversante 504'.

Au cours d'une étape E4, on obtient la barre omnibus auxiliaire négative BA'-.

Au cours d'une étape E5, la portion BA1'- de la barre omnibus auxiliaire négative BA'- est plaquée et fixée contre la portion de fixation B1'- de la broche négative B'-. La fixation est par exemple réalisée par soudage, par exemple par brasure électrique et/ou par dépôt d'un maillon d'argent entre les deux portions BA1'-, B1'- à fixer.

Au cours d'une étape E6, on obtient la branche positive B'+ comprenant les portions B1'+, B2'+.

Au cours d'une étape E7, la broche positive B'+ est insérée, par sa portion de fixation B1'+, dans le tore 304', en décalant, par exemple vers le haut comme dans l'exemple illustré, sa portion de fixation B1'+ de la portion de fixation B1'- de la broche négative B'-. En particulier, comme dans l'exemple illustré, la broche positive B'+ est insérée dans l'ouverture traversante 504' du surmoulage 502', de sorte que le tore 304' entoure la portion de fixation B1'+ de la broche positive B'+.

Au cours d'une étape E8, on obtient la barre omnibus auxiliaire positive BA'+.

Au cours d'une étape E9, la portion BA1'+ de la barre omnibus auxiliaire positive BA'+ est plaquée et fixée contre la portion de fixation B1'+ de la broche positive B'+. Cette fixation est facilitée par le décalage entre les portions de fixation B1'+, B1'- des broches B'-, B'+, qui permet un accès par les deux côtés. La fixation est par exemple réalisée par soudage.

Au cours d'une étape E10, la broche positive B'+ est glissée vers le bas dans le tore 304' pour placer les portions de fixation B1'+, B1'- en vis-à-vis l'une de l'autre. Par exemple, comme dans l'exemple illustré, la broche positive B'+ est glissée vers le bas dans l'ouverture traversante 504' du surmoulage 502'.

Une fois le connecteur 226 obtenu par le procédé de fabrication d'un connecteur tel que décrit précédemment, ce connecteur est assemblé aux deux barres omnibus principales positive BP+ et négative BP- du convertisseur de tension continu-continu 114 selon un procédé d'assemblage comprenant une étape d'obtention F1 d'un connecteur 226 selon le procédé de fabrication d'un connecteur précédemment décrit, et une étape de plaquage et de fixation de la portion plane BP2+ de la barre omnibus principale positive BP+ et de la portion plane BP2- de la barre omnibus principale négative BP- contre respectivement les deuxièmes portions planes BA2+, BA2- des barres omnibus auxiliaires BA+, BA-.

En particulier cette étape de placage et de fixation de la portion plane BP2+ de la barre omnibus principale positive BP+ et de la portion plane BP2- de la barre omnibus principale négative BP- contre respectivement les deuxièmes portions BA2+, BA2- des barres omnibus auxiliaires BA+, BA- comprend une étape de fixation par vissage des deuxièmes portions BA2+, BA2- des barres omnibus auxiliaires BA+, BA- aux portions planes BP2+, BP2- des barres omnibus principales BP+, BP- selon une direction de vissage sensiblement perpendiculaire aux deuxièmes portions BA2+, BA2- des barres omnibus auxiliaire BA+, BA-.

On notera ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué.

Dans la présentation détaillée de l'invention qui est faite précédemment, les termes utilisés ne doivent pas être interprétés comme limitant l'invention aux modes de réalisation exposés dans la présente description, mais doivent être interprétés pour y inclure tous les équivalents dont la prévision est à la portée de l'homme de l'art en appliquant ses connaissances générales à la mise en oeuvre de l'enseignement qui vient de lui être divulgué.

## Revendications

1. Convertisseur électrique continu-continu (114) comportant :
- un circuit électrique de conversion (218) conçu pour convertir une tension d'entrée (VIN) continue en une tension de sortie (VOUT) continue ;
- un connecteur d'entrée ou bien de sortie (226), dit premier connecteur, comportant :
• deux broches (B+, B-), l'une (B+) positive et l'autre (B-) négative, conçues pour recevoir la tension d'entrée (VIN) ou bien pour fournir la tension de sortie (VOUT), et
• deux barres omnibus auxiliaires plates (BA+, BA-), l'une (BA+) positive et l'autre (BA-) négative, chaque barre omnibus auxiliaire plate (BA+, BA-) comportant une première portion plane (BA1+, BA1-) plaquée et fixée contre la broche positive (B+), respectivement négative (B-), et une deuxième portion plane (BA2+, BA2-), ces deuxièmes portions planes (BA2+, BA2-) étant sensiblement parallèles l'une à l'autre, par exemple coplanaires, la première portion plane (BA1+) de la barre omnibus auxiliaire plate positive (BA+) étant plaquée et fixée contre une portion de fixation plane (B1+) de la broche positive (B+), et la première portion plane (BA1-) de la barre omnibus auxiliaire plate négative (BA-) étant plaquée et fixée contre une portion de fixation plane (B1-) de la broche négative (B-) et comportant une portion de liaison directement adjacente à la première portion (BA1+, BA1-) et à la deuxième portion (BA2+, BA2-) ; et
- deux barres omnibus principales positive (BP+) et négative (BP-) connectées au circuit électrique de conversion (218) et comportant respectivement des portions planes (BP2+, BP2-) plaquées et fixées respectivement contre les deuxièmes portions (BA2+, BA2-) des barres omnibus auxiliaire (BA+, BA-).

2. Convertisseur électrique continu-continu (114) selon la revendication 1, la portion de liaison de chaque barre omnibus auxiliaire comprend une pliure (P+, P-) de sorte que la première portion (BA1+, BA1-) et la deuxième portion (BA2+, BA2-) de chaque barre omnibus auxiliaire (BA+, BA-) fassent entre elles un angle non plat.

3. Convertisseur électrique continu-continu (114) selon la revendication 2, dans lequel la portion de liaison comprend une unique pliure (P+, P-) reliant la première portion (BA1+, BA1-) et la deuxième portion (BA2+, BA2-) de chaque barre omnibus auxiliaire (BA+, BA-).

4. Convertisseur électrique continu-continu (114) selon l'une des revendications 1 à 3, la portion de liaison de chaque barre omnibus auxiliaire (BA+, BA-) est dans un sens de circulation du courant au sein de la barre omnibus auxiliaire (BA+, BA-) plus courte que la première portion (BA1+, BA1-) et que la deuxième portion (BA2+, BA2-) de la barre omnibus auxiliaire (BA+, BA-).

5. Convertisseur électrique continu-continu (114) selon l'une quelconque des revendication 1 à 4, dans lequel les deuxièmes portions (BA2+, BA2-) des barres omnibus auxiliaires (BA+, BA-) sont fixées aux barres omnibus principales (BP+, BP-) par vissage selon une direction de vissage sensiblement perpendiculaire aux deuxièmes portions (BA2+, BA2-) des barres omnibus auxiliaire (BA+, BA-).

6. Convertisseur électrique continu-continu (114) selon l'une quelconque des revendications 1 à 5, dans lequel les premières portions (BA1+, BA1-) des barres omnibus auxiliaires (BA+, BA-) sont fixées aux portions de fixation planes (B1+, B1-) des broches (B+, B-) par soudage.

7. Convertisseur électrique continu-continu (114) selon l'une quelconque des revendications 1 à 6, comportant un boîtier (202) muni d'un fond (206) avec au moins une partie plane, et dans lequel les deuxièmes portions (BA2+, BA2-) des barres omnibus auxiliaires (BA+, BA-) sont sensiblement parallèles à la partie plane du fond (206).

8. Convertisseur électrique continu-continu (114) selon l'une quelconque des revendications 1 à 7, dans lequel les portions de fixation planes (B1+, B1-) des broches (B+, B-) s'étendent sensiblement parallèlement l'une en face de l'autre et présentent des faces en vis-à-vis et des faces externes, de l'autre côté des faces en vis-à-vis, sur lesquelles les premières portions (BA1+, BA1-) des barres omnibus auxiliaires (BA+, BA-) sont plaquées et fixées.

9. Convertisseur électrique continu-continu (114) selon la revendication 8, dans lequel chaque broche (B+, B-) comporte une portion d'extrémité (B2+, B2-) planes, ces portions d'extrémité (B2+, B2-) s'étendant sensiblement parallèlement l'une en face de l'autre, à une distance plus grande que les portions de fixation (B1+, B1-), et dans lequel le connecteur (224, 226) comporte en outre un tore magnétique (304) entourant les portions de fixation (B1+, B1-) des broches (B+, B-).

10. Convertisseur électrique continu-continu (114) selon la revendication 9, dans lequel le connecteur (224, 226) comporte en outre :
- une première capacité (C+) connectée entre la broche positive (B+) et une masse électrique, cette première capacité (C+) étant connectée à la broche positive (B+) entre le tore magnétique (304) et sa portion d'extrémité (B2+) ; et/ou
- une deuxième capacité (C-) connectée entre la broche négative (B-) et la masse électrique, cette deuxième capacité (C-) étant connectée à la broche négative (B-) entre le tore magnétique (304) et sa portion d'extrémité (B2-).

11. Convertisseur électrique continu-continu (114) selon l'une quelconque des revendications 1 à 10, comportant un autre connecteur (224) d'entrée ou bien de sortie, similaire au premier connecteur (226), les première et deuxième portions planes (BA1'+, BA1'-, BA2'+, BA2'-) des barres omnibus auxiliaire (BA'+, BA'-) de cet autre connecteur (224) faisant entre elles un angle différent de l'angle entre les première et deuxième portions planes (BA1+, BA1-, BA2+, BA2-) du premier connecteur (226), de sorte que les deuxièmes portions planes (BA2'+, BA2'-) de cet autre connecteur (224) soient parallèles à celles (BA2+, BA2-) du premier connecteur (226) .

12. Convertisseur électrique continu-continu (114) selon la revendication 11, dans lequel les broches positives (B+, B'+) et les broches négatives (B-, B'-) des deux connecteurs (224, 226) sont identiques, en particulier de même forme.

13. Engin de mobilité comportant un convertisseur électrique continu-continu (114) selon l'une quelconque des revendications 1 à 12.
